# FASCICULE DE BREVET EUROPEEN

(11) **EP 2 915 094 B1**
(45) Date de publication et mention de la délivrance du brevet: **18.01.2017**
(21) Numéro de dépôt: 13792608.5
(22) Date de dépôt: 28.10.2013
(51) Int. Cl.: G06K 7/00

(54) **CORPS DE LECTEUR DE CARTE À MÉMOIRE SÉCURISÉ**
KARTENLESERKÖRPER MIT GESICHERTEN SPEICHER
CARD READER BODY WITH SECURED MEMORY

(30) Priorité: 30.10.2012 FR 1260357
(43) Date de publication de la demande: 09.09.2015
(73) Titulaire: Ingenico Group, 75015 Paris (FR)
(72) Inventeur: PAVAGEAU, Stéphane, F-26600 La Roche de Glun (FR)
(74) Mandataire: Vidon Brevets & Stratégie
(86) Numéro de dépôt international: PCT/EP2013/072528
(87) Numéro de publication internationale: WO 2014/067905

(56) Documents cités:
- FR-A1- 2 793 921
- GB-A- 2 411 756

## Description

### 1. Domaine de l'invention

L'invention se situe dans le domaine des lecteurs de carte à mémoire. L'invention a plus particulièrement comme objet un lecteur de carte à mémoire destiné à être inséré dans un terminal de lecture de cartes à mémoire. Un tel terminal peut être un terminal de paiement, un terminal d'identification. Plus généralement, l'invention se rapporte à tout type de terminal pouvant comprendre un lecteur de carte à mémoire.

### 2. Art Antérieur

Les terminaux de lecture de cartes à mémoire comprennent, outre un lecteur de cartes à mémoires, un certain nombre de composants tels qu'un clavier, un écran, un ou plusieurs processeurs, de la mémoire, une source d'alimentation électrique. Depuis plusieurs années, les terminaux de lecture de cartes à mémoire ont vu leurs fonctions être multipliées. Ceci est particulièrement vrai pour les terminaux de paiement. Outre la fonction de paiement, les terminaux embarquent des fonctions de communication en réseau, des fonctions de détection de cartes à mémoire sans contact (cartes « contactless »), des fonctions de gestion de coupons (par exemple des coupons de fidélité), etc.

En plus de la multiplication de telles fonctions auxiliaires, les terminaux de lecture de cartes à mémoire doivent en plus être résistants aux diverses attaques ou tentatives de fraudes dont ils font fréquemment l'objet. Afin d'obtenir une homogénéité de la résistance des terminaux aux attaques, des normes internationales ont été édictées. Dans le domaine du paiement, par exemple, la norme PCI PED (« Payment Card Industry - Pin Entry Device) édicte des exigences en matière d'intrusion et de détection des tentatives d'attaques sur les terminaux. Il ne s'agit pas de la seule norme en vigueur.

Cependant, du fait de ces normes, les terminaux qui étaient antérieurement peu protégés laissent progressivement la place à des terminaux de plus en plus sécurisés. Parmi les points de sécurisation des terminaux, les industriels du secteur veillent plus particulièrement à la protection du lecteur de carte à mémoire. Le lecteur de carte à mémoire, en effet, reste un maillon faible du terminal de lecture de carte à mémoire. Ceci est dû au fait que le lecteur de carte à mémoire comprend une fente d'insertion de la carte à mémoire, cette fente rendant l'intérieur du terminal accessible depuis l'extérieur. Plus particulièrement, des attaquants cherchent à se procurer un accès au connecteur de carte à mémoire. Le connecteur de carte à mémoire est la partie du lecteur de carte à mémoire qui entre en contact avec la puce ou le microprocesseur embarqué sur la carte à mémoire. Lorsqu'un attaquant parvient à avoir accès à ce connecteur de carte à mémoire sans que quiconque s'en aperçoive, il est alors possible d'intercepter et de lire les données qui sont échangées entre la puce ou le microprocesseur de la carte et le processeur du terminal de lecture de carte à mémoire. Parmi les données interceptées, on peut notamment citer le code secret saisi par le client lors de la demande de code secret, qui peut être véhiculé sans cryptage, sur certaines cartes à puce.

Ceci explique que de nombreux efforts ont été portés à la sécurisation du lecteur de carte à mémoire. Ainsi, par exemple, les lecteurs de carte à mémoire ont été pourvus d'une protection avec treillis. Cette protection permet d'éviter une introduction par perçage du terminal. Lorsqu'un objet tente de pénétrer dans l'enceinte de protection, un court-circuit est produit entraînant alors une mise hors service du terminal.

Par ailleurs, des modifications visant à protéger les connecteurs de carte à mémoire contre les décharges électrostatiques et contre l'usure ont également été proposées. Il s'agit *par exemple* de disposer, à l'entrée du lecteur de carte à mémoire, de pièces métalliques assurant le guidage mécanique (prévention contre l'usure) et/ou la décharge de la carte préalablement à son insertion dans le lecteur de carte à mémoire. Communément, ces pièces métalliques se présentent sous la forme de tiges métalliques de guidage de quelques millimètres de hauteur. Un autre exemple consiste à ajouter des pièces métalliques qui se présentent sous la forme d'un peigne de décharge de la carte.

Toutes ces modifications ont entrainé une complexité de fabrication importante. Par ailleurs, le coût de fabrication a également augmenté. Actuellement, les exigences normatives en matière de sécurité sont telles qu'il est nécessaire de prévoir, pour la fabrication d'un terminal de lecture, de nombreuses étapes qui mêlent à la fois les soudures échelonnées de composants, la nécessité de disposer de composants résistants à la refusion, etc. Outre la complexité de fabrication du terminal de lecteur de carte à mémoire, ces procédés rendent la maintenance des terminaux produits très complexe voire impossible, suscitant ainsi bien des difficultés pour les prestataires de services de maintenance autant que pour le fabricant du terminal de lecture de carte à mémoire

FR 2 793 921 divulgue un ensemble compact pour le raccordement d'une carte à circuit(s) intégré(s); GB 2 411 756 divulgue une méthode de sécurisation d'un lecteur de carte contre des intrusions par moyen de pistes conductrices.

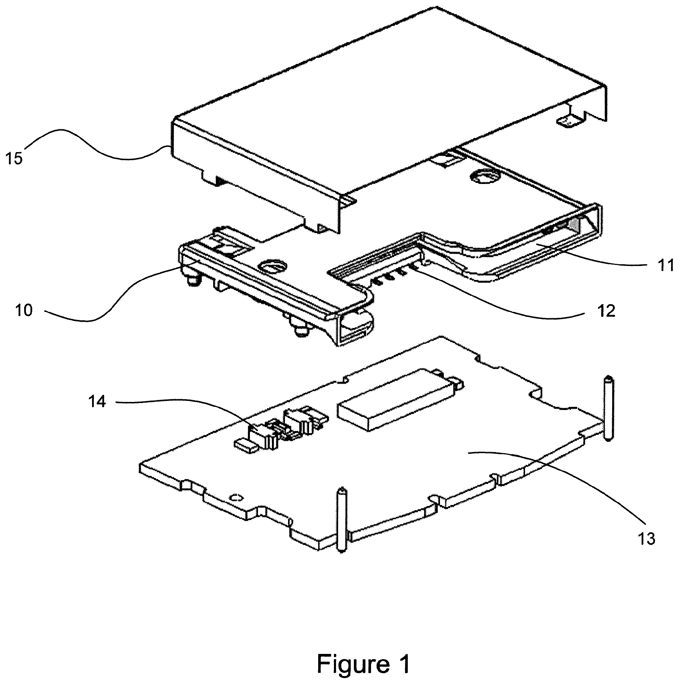

On décrit, en relation avec la figure 1, un assemblage classique d'un lecteur de carte à mémoire. Ce lecteur de carte à mémoire comprend un corps de lecteur de carte à mémoire 10, comprenant une fente d'insertion d'une carte à mémoire 11. Le connecteur de carte à mémoire est directement intégré au sein du lecteur de carte à mémoire. Il comprend des pins 12 de connexion au circuit imprimé (PCB) 13 (vue partielle). Le PCB 13 comprend également des composants électroniques 14. Pour protéger le lecteur de cartes à mémoire 10, celui-ci est recouvert d'une protection complète 15, ainsi que d'une protection frontale 15b.

Il existe donc un besoin de fournir une architecture de lecteur de carte à mémoire qui soit intrinsèquement sécurisée et ne nécessite pas de protection complémentaire.

### 3. Résumé de l'invention

L'invention se rapporte ainsi à un corps de lecteur de carte à mémoire.

Plus particulièrement, l'invention se rapporte à un corps de lecteur de carte à mémoire de forme globalement parallélépipédique rectangle comprenant une fente d'insertion d'une carte à mémoire.

Selon l'invention, un tel corps de lecteur comprend, sur une face postérieure 21, un logement de réception d'un connecteur de carte à mémoire, ledit logement de réception étant d'une forme volumique prédéterminée et comprenant au moins une piste conductrice.

Ainsi l'invention permet de faciliter le montage. En effet, de par la configuration du corps de lecteur de carte à mémoire, l'invention permet de souder d'abord le connecteur de carte à mémoire sur le PCB puis de fixer ensuite le corps du lecteur de carte à mémoire sur le PCB en recouvrant le connecteur de carte à mémoire. De manière complémentaire, cette architecture de lecteur de carte à mémoire permet également de fixer d'autres composants sur le PCB, le corps du lecteur de carte à mémoire venant en outre recouvrir ces autres composants par la suite. De plus, comme le logement de réception comprend un dispositif de protection dudit connecteur de carte à mémoire, il devient extrêmement délicat de s'introduire à proximité du connecteur de carte à mémoire. La face postérieure du corps du lecteur est celle qui est destinées à recouvrir le connecteur de carte à mémoire lors de l'assemblage de l'ensemble sur un PCB de destination..

Selon une caractéristique particulière, ladite forme volumique dudit logement de réception est sensiblement égale à la forme volumique du connecteur de carte à mémoire.

Ainsi, l'invention permet limiter le volume laissé libre entre le logement du corps du lecteur de carte à mémoire et le connecteur de carte à mémoire. Plus particulièrement, le volume laissé libre correspond au volume nécessaire au passage de la carte à mémoire.

Selon une caractéristique particulière, ladite face postérieure dudit corps de lecteur de carte à mémoire comprend en outre au moins un logement complémentaire de réception d'au moins un composant électronique.

Ainsi, l'invention permet également d'assurer une protection d'un ou plusieurs composants électroniques complémentaires qui sont recouverts par le lecteur le carte à mémoire lorsque celui-ci est fixé sur le PCB.

Selon une caractéristique particulière, dans ledit logement de réception, ledit corps de lecteur de carte à mémoire comprend au moins un circuit de protection.

Selon l'invention, un tel corps du lecteur de carte à mémoire comprend, sur la face postérieure du corps du lecteur, également appelée face interne, au moins une piste de protection, ladite piste couvrant au moins une surface sensiblement équivalente à un volume d'un emplacement libre dudit corps de lecteur carte à mémoire.

Ainsi, selon l'invention, il n'est plus nécessaire de disposer de flexible de protection au-dessus du corps du lecteur de carte à mémoire. En effet, selon l'invention, le corps du lecteur de carte à mémoire intègre directement la (les) piste(s) qui offre(nt) la même fonction que le flexible de protection et la protection frontale. En outre, comme il n'est plus nécessaire de disposer des éléments de protection de l'art antérieur, l'invention permet une simplification du montage du terminal de lecture puisqu'elle supprime plusieurs étapes de montage, et permet également de supprimer le coût de ces protections.

Selon un mode de réalisation particulier, ledit circuit de protection se présente sous la forme d'au moins un treillis comprenant ladite au moins une piste conductrice.

Selon un mode de réalisation particulier, ledit circuit de protection se présente sous la forme d'au moins une piste électrique continue comprenant ladite au moins une piste conductrice.

Par exemple, cette piste peut être obtenue par l'utilisation de la technique dite MID (« molded interconnected device ») ou par d'autres procédés.

Selon un mode de réalisation particulier, caractérisé en ce que ledit circuit de protection est réalisé par une technique de gravure au laser.

Cette technique de gravure au laser est couplée à des bains chimiques et se nomme dite « LDS » (de l'anglais pour « Laser Direct Structuring »).

Selon une caractéristique particulière, ledit circuit de protection est un circuit imprimé flexible positionné au sein dudit logement de réception.

Selon une caractéristique particulière, ladite face postérieure dudit lecteur de carte à mémoire comprend au moins un logement complémentaire de réception d'au moins un composant électronique, et en ce que ledit logement complémentaire est positionné sous ledit circuit de protection.

Selon une caractéristique particulière, ladite au moins une piste conductrice est conformée pour définir des zones de décharges électrostatiques entrant en contact avec une carte à puce lors de l'introduction de ladite carte à puce dans ledit corps de lecteur.

L'invention se rapporte également à un terminal de lecture de carte à mémoire. Selon l'invention, un tel terminal comprend un corps du lecteur de carte à mémoire tel que décrit préalablement.

### 4. Figures

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :
- la figure 1, déjà présenté, expose l'architecture classique d'un lecteur de carte à mémoire.
- La figure 2 illustre le principe général de l'invention à savoir la séparation en deux unités fonctionnelles distinctes du connecteur de carte à mémoire et du corps du lecteur de carte à mémoire ;
- les figures 3 et 4 illustrent un mode de réalisation de l'invention dans lequel le corps du lecteur de carte à mémoire comprend une piste de détection d'intrusion ;

### 5. Description détaillée

### 5.1. Rappel du principe de l'invention.

Le principe général de l'invention consiste à proposer une architecture de lecteur de carte à mémoire qui intègre directement les contraintes fonctionnelles inhérentes au fonctionnement de ce type de dispositif. Plus particulièrement, le principe général de l'invention consiste à découper le lecteur de carte à mémoire en deux parties distinctes : une première partie par laquelle transitent les signaux de cartes à mémoire, ainsi que le switch de détection de présence carte , et pouvant assurer une partie résiduelle de la décharge électrostatique, (il s'agit du connecteur de carte à mémoire) et une deuxième partie permettant l'insertion de la carte à mémoire, assurant d'une part le guidage et les reprises d'effort de la carte à mémoire, d'autre part une partie de la décharge électrostatique de la carte, et aussi une protection des signaux échangés entre la carte à mémoire et le connecteur de carte à mémoire.(il s'agit du corps du lecteur de carte à mémoire proprement dit).

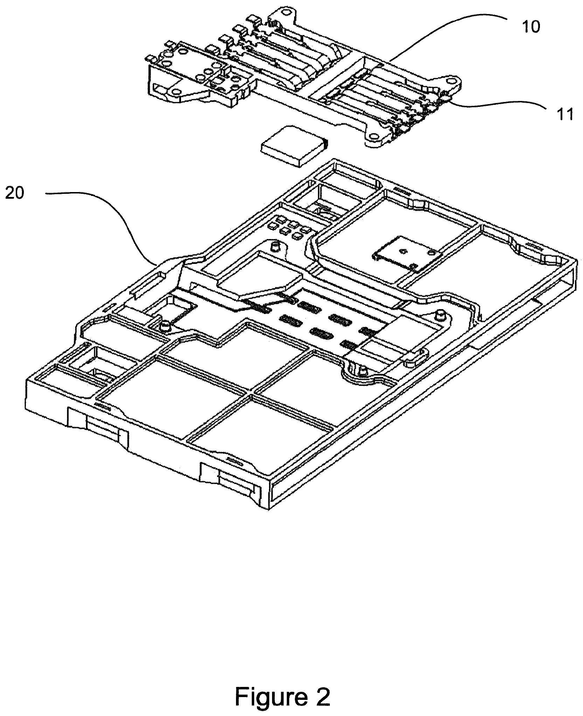

Le principe général de l'invention est décrit en relation avec la figure 2. Selon l'invention, un connecteur de carte à mémoire 10 est construit indépendamment d'un corps du lecteur de carte à mémoire 20. Le connecteur de carte à mémoire 10 est conçu afin de permettre une lecture des signaux émanant de la carte à mémoire (non représentée). Dans la figure 1, le connecteur de carte à mémoire 10 est conçu pour la lecture d'une carte à puce. Pour ce faire, le connecteur de carte à mémoire 10 comprend un certain nombre de pins 11 (huit sur la figure 2), permettant d'entrer en contact avec des zones correspondantes de la carte à mémoire (six ou huit zones en fonction de la carte à mémoire). Les pins 11 sont en général des lames ressort métalliques qui se positionnent sur la surface de la puce. L'objet de la divulgation n'étant pas ce connecteur, sa description détaillée ne sera pas réalisée plus avant.

Selon l'invention, en revanche, ce connecteur de carte à mémoire 10 est indépendant du corps du lecteur de carte à mémoire 20. Cela signifie que contrairement aux systèmes de l'art antérieur, le connecteur de carte à mémoire 10 n'est pas assemblé avec le corps du lecteur de carte à mémoire 20 avant d'être assemblé au PCB du terminal de lecture. L'invention propose de fixer le connecteur de carte à mémoire 10 en premier sur le PCB, puis ensuite de fixer le corps du lecteur de carte à mémoire 20 par-dessus le connecteur 10. En d'autres termes, on comprend que cet assemblage n'est pas du tout de même nature que l'assemblage de l'art antérieur puisque le connecteur de carte à mémoire est recouvert par le corps du lecteur de cartes à mémoire qui vient en quelque sorte le protéger. On connaît dans d'autres domaines, des terminaux dans lesquels le capot inférieur du terminal (c'est-à-dire son enveloppe extérieure) fait office de corps de lecteur. Cependant, à la différence de l'invention, ce capot n'est pas protégé et ne permet pas la mise en oeuvre de procédure de sécurisation. Ce corps de lecteur ne comprend aucune piste et ne remplit pas les fonctions décrites ici. Plus particulièrement, ce corps de lecteur ne comprend pas de piste tant sur sa face postérieure pour réaliser une protection du terminal que dans une autre portion du lecteur pour par exemple réaliser une décharge électrostatique de la carte à mémoire préalablement à son insertion.

De manière additionnelle, dans au moins un mode de réalisation, l'invention propose de supprimer le flexible de protection qui recouvre entièrement le lecteur de carte à mémoire. Dans un mode de réalisation, l'invention remplace ce flexible de protection par un dispositif de protection interne, i.e. qui se trouve à l'intérieur du corps lecteur de cartes à mémoire 20 lui-même.

Par la suite, on décrit un mode de réalisation spécifique de l'invention. Il est entendu que ce mode de réalisation ne limite en rien la portée de l'invention. Plus particulièrement, dans d'autres modes de réalisation de l'invention il est possible de protéger le connecteur de carte à mémoire en utilisant d'autres moyens de gravure de pistes électriques que ceux décrits par la suite (par exemple, un circuit flexible collé à l'intérieur du corps du lecteur).

### 5.2. Description d'un mode de réalisation détaillé

Dans ce mode de réalisation de l'invention, un dispositif de protection interne est positionné dans le corps du lecteur de carte à mémoire. Dans ce mode de réalisation, le dispositif de protection se présente sous la forme de pistes électriques intégrées au corps du lecteur de carte à mémoire 20 à proximité de la zone de contact des pins du connecteur de cartes à mémoire 10 lorsque le corps du lecteur de carte à mémoire recouvre le connecteur de carte à mémoire.

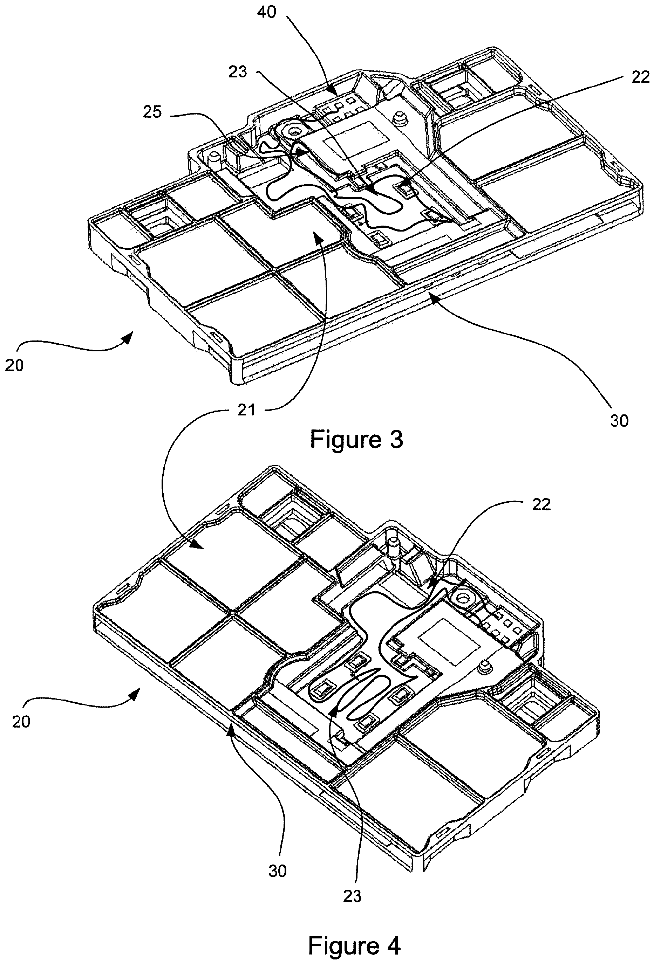

Ce mode de réalisation est présenté plus particulièrement en relation avec les figures 2 et 3. Comme indiqué, précédemment, on vient rapporter une pièce complémentaire (le corps du lecteur de carte à mémoire 20) par-dessus le connecteur de carte à mémoire 10. Dans ce mode de réalisation de l'invention, le corps du lecteur de carte à mémoire 20 est une pièce en plastique. Outre ses fonctions d'insertion et de maintien et de reprise d'efforts de la carte à mémoire, par exemple la carte à puce, le corps du lecteur de carte à mémoire 20 protège également le signal I/O transitant entre la carte à mémoire (carte à puce) et le connecteur de carte à mémoire 10, au plus près du signal à protéger (la surface structurée est donc plus petite et la protection est meilleure qu'avec un blindage souple extérieur au lecteur de carte à mémoire).

Dans ce mode de réalisation, le corps du lecteur de carte à mémoire 20 est une pièce de forme globalement parallélépipédique rectangle, d'une largeur d'environ soixante millimètres, d'une profondeur d'environ quarante millimètres et d'une hauteur d'environ quatre millimètres. Le corps du lecteur de carte à mémoire 20 comprend une fente d'insertion 30, d'une hauteur comprise entre 0.8 et 1.5 millimètres. La fente d'insertion 30 permet d'insérer la carte à mémoire dans une position correcte pour qu'elle entre en contact avec le connecteur de carte à mémoire 10. Le lecteur de carte à mémoire comprend également, sur sa face postérieure 21, un logement 22, destiné à recevoir et à recouvrir le connecteur de carte à mémoire 10. La forme volumique de ce logement de réception22 est sensiblement complémentaire à la forme volumique du connecteur de carte à mémoire 10, moyennant bien entendu l'espace nécessaire à la présence de la carte à mémoire. Ainsi, le connecteur de carte à mémoire 10, et plus spécifiquement les pistes par lesquelles transitent les signaux I/O sont recouverts par le corps du lecteur de carte à mémoire 20. En outre, dans le logement 22, le corps du lecteur de carte à mémoire comprend au moins un circuit de protection 23. Ce circuit de protection 23 peut être un circuit tridimensionnel. Ce circuit de protection 23 se présente par exemple sous la forme d'un ou de plusieurs treillis de détection d'intrusion ou sous la forme d'une ou de plusieurs pistes continues de détection d'intrusion (par exmple un circuit de masse, et deux treillis à des potentiels différents). Ce circuit de protection 23 est positionné dans le logement 22, sur la face postérieure de la carte à mémoire. Il est également positionné sur les arêtes latérales 24 du logement. Par ailleurs, le circuit de protection est étagé : cela signifie que le circuit de protection 23 ne se situe pas dans un seul plan, mais dans plusieurs (au moins deux). Ainsi, on assure que le circuit de protection 23 recouvre sensiblement la forme volumique du connecteur de carte à mémoire 10 Dans ce mode de réalisation, le corps du lecteur de carte à mémoire 20 comprend en outre au moins un logement complémentaire 40 de réception d'au moins un composant électronique.

Plus particulièrement, le corps du lecteur de carte à mémoire, dans un mode de réalisation particulier de l'invention est une pièce dite MID (de l'anglais pour *« Moulded Interconnect Device »).* Plus particulièrement, le corps du lecteur de carte à mémoire MID permet de protéger deux surfaces en parties opposées. En effet, une gravure au laser est réalisée afin de produire des pistes électroniques en trois dimensions. L'emploi de cette technique est inhabituel dans le domaine de l'invention.

Dans un mode de réalisation, la pièce en LDS (de l'anglais pour « Laser Direct Structuring »), possède une surface interne qui revient en partie supérieure (référence 24 sur les figures 2 et 3), ce qui permet de réaliser une protection complète en MID, dans toutes les directions. Dans ce mode de réalisation de l'invention, la gravure MID permet de réaliser un ou plusieurs treillis, le(s)dit(s) treillis étant classiquement une protection permettant de détecter l'insertion d'un dispositif dans le corps du lecteur de carte à mémoire. L'utilisation d'un treillis pour détecter une insertion ou une tentative de perçage est une technique connue dans le domaine de l'invention. Cependant, à la différence de l'art antérieur, l'invention intègre directement le treillis en surface interne du connecteur de carte à mémoire, et ce, d'une façon très intégrée.

En d'autres termes, la gravure laser est réalisée dans les trois dimensions afin de se conformer au volume du connecteur de carte à mémoire, et plus particulièrement de se situer à proximité de l'émission/réception des signaux provenant de la carte. On définit ainsi un treillis en trois dimensions qui est adapté à la forme du connecteur de carte à mémoire et non plus un flexible de taille démesurée, ainsi qu'un autre élément pour la protection frontale compte tenu de la zone à protéger.

Plus particulièrement, la distance entre la gravure définissant les pistes de protection et les pins du connecteur de carte à mémoire est de l'ordre du dixième de millimètre.

On comprend donc, qu'avec cet ordre de grandeur, il est nettement plus complexe de réaliser une attaque sur le connecteur de carte à mémoire en tentant d'insérer un dispositif. Ainsi, en une seule pièce, l'invention permet de descendre la protection en partie inférieure du connecteur, (partie en contre dépouille) sans ajouter de phase complémentaire, ni de connexion intermédiaire.

Le corps du lecteur s'occupe aussi de régler les problèmes de butée de la carte. Il ne requiert pas que la butée soit effectuée par le connecteur électrique, qui, lui, a uniquement des fixations au circuit imprimé électronique, soudées en refusion (donc d'une tenue relativement faible par rapport aux contraintes généralement constatées,

Il convient également de noter que le corps du lecteur peut être deux parties et clipsable et lien entre les deux parties recouvrables et qu'il n'y a pas de possibilité de séparation ultérieure (sauf à dégrader le treillis, et donc à déclencher une réponse de protection). Dans ce cas, le(s) treillis peuvent également être plus conséquents, car il n'est pas nécessaire qu'ils soient visibles pour des questions de processus de construction.

### 5.3. Caractéristiques complémentaires

Dans certains modes de réalisation, combinés ou non aux caractéristiques décrites précédemment, le corps du lecteur de carte à mémoire tel que défini comprend, une zone de décharge (dite zone ESD) permettant de réaliser une première décharge de la carte à mémoire lorsque celle-ci est insérée dans le lecteur. Plus particulièrement, afin de conserver la propriété d'unicité du corps du connecteur de carte à mémoire, cette zone de décharge électrostatique est produite en utilisant la technologie MID. Dans un premier mode de réalisation de cette zone de décharge se situe à proximité de la zone d'insertion de la carte à mémoire, sensiblement à l'endroit où la puce de la carte à mémoire doit se situer lors de l'insertion. Plus particulièrement, le corps du lecteur est configuré pour que la puce de la carte entre en contact avec cette zone de décharge.

Dans un deuxième mode de réalisation de cette zone de décharge se situe à l'intérieur du corps du lecteur, plus particulièrement sur la face interne des flancs du corps du lecteur. Plus particulièrement, la face interne des flancs du corps du lecteur est configurée pour qu'au moins une tranche de la carte entre en contact avec cette zone de décharge.

Selon une autre caractéristique, afin d'éviter la problématique de la soudure du treillis de protection (sur la face interne du corps du connecteur de carte à mémoire) sur le PCB, la connexion entre ces deux éléments est réalisée par l'intermédiaire d'un connecteur élastomère, par exemple de type Zebra (Marque déposée). Ainsi, il n'est pas nécessaire de disposer d'un mécanisme complexe de soudure du corps de lecteur de carte à mémoire sur le PCB : en effet, comme la connexion est assurée par l'intermédiaire d'un connecteur élastomère, le montage de l'ensemble connecteur de carte à mémoire, connecteur élastomère et corps de lecteur de carte à mémoire est facilité.

Plus généralement, pour faciliter le montage, les étapes suivantes sont mises en oeuvre :
- Une étape de fixation du connecteur de carte à mémoire sur le PCB. Cette fixation peut être réalisée par vissage ou par soudure ou par collage ou par une combinaison de ces méthodes. D'autres méthodes de fixation peuvent également être employées.
- Une étape de pose du connecteur élastomère (lorsqu'il est employé). Le positionnement du connecteur élastomère peut avantageusement être réalisé dans une zone laissée libre à cet effet au sein du connecteur de carte à mémoire.
- Une étape de pose et de fixation du corps du lecteur de carte à mémoire, avec un mode de fixation du corps du lecteur par rapport au PCB. Dans le cas d'un Zebra, une vis se prenant dans une partie du connecteur de carte à mémoire est une solution avantageuse, ou encore l'ajout d'une cinquième PIN faisant office de maintien mécanique.

Ainsi, il ne faut que deux ou trois étapes pour assembler et fixer le lecteur de carte à mémoire sur le PCB.

### 5.4. Description d'un mode de réalisation d'un lecteur de carte à mémoire

Ce mode de réalisation est plus particulièrement décrit en relation avec la figure 4. Pour plus de simplicité, les références numériques qui ont été préalablement employées dans les figures 2 et 3 sont conservées. Dans ce mode de réalisation, le lecteur de carte à mémoire comprend un corps de lecteur de carte à mémoire 20, un connecteur de carte à mémoire 10 et un connecteur élastomère 30. Le connecteur de carte à mémoire 10 est architecturé de sorte qu'il comprenne un espace laissé libre ECE pour le positionnement du connecteur élastomère 30. Ainsi, lors de l'assemblage le connecteur de carte à mémoire 10 est d'abord fixé sur le PCB, puis le connecteur élastomère 30 est inséré dans l'espace ECE. Le corps du lecteur de carte à mémoire 20 est ensuite positionné par-dessus l'ensemble formé par le connecteur de carte à mémoire et le connecteur élastomère. Comme cela a déjà été mentionné, le corps du connecteur de carte à mémoire 20 comprend une zone de décharge de la carte 25. Le connecteur de carte à mémoire 20 est fixé au PCB par l'intermédiaire d'une vis 26 et de quatre pions d'ancrage 27. La vis 26 sert également à assurer une pression permanente dans le temps. La vis 26 se visse dans le connecteur carte à mémoire, qui est lui-même fixé au PCB par soudure. La liaison est donc directe. Les pions d'ancrage ont une forme particulière, adaptée d'une part pour remplir une fonction de guidage de la carte à mémoire dans le lecteur et d'autre part pour réaliser, si besoin, une décharge électrostatique des arêtes de la carte insérée.

De plus, dans ce système, les centrages entre le connecteur de carte à mémoire et le corps du lecteur de carte à mémoire permettent de se positionner de façon rigoureuse.

En effet, dans ce mode de réalisation, le connecteur de carte à mémoire comprend au moins deux orifices de centrage. Les orifices de centrage sont configurés de sorte que des plots de centrage, qui sont intégrés au corps du lecteur de carte à mémoire, puissent prendre place dans ces orifices de centrage. Ainsi, dans ce mode de réalisation, il n'est pas possible de réaliser un mauvais montage du lecteur de carte à mémoire. Plus particulièrement, il n'est pas possible de placer le corps du lecteur de carte à mémoire avec un angle incorrect pas rapport au connecteur.

## Revendications

1. Corps de lecteur de carte à mémoire (20) de forme globalement parallélépipédique rectangle comprenant une fente d'insertion (30) d'une carte à mémoire, le corps de lecteur comprend, sur une face postérieure (21), un logement de réception (22) d'un connecteur de carte à mémoire (10), ledit logement de réception (22) étant d'une forme volumique prédéterminée **caractérisé en ce que** le corps de lecteur de carte à mémoire (20) comprend sur la face postérieure (21) du corps de lecteur au moins une piste conductrice de protection à proximité d'une zone de contact de pins du connecteur de carte à mémoire (10), ladite piste couvrant au moins une surface sensiblement équivalente à un volume d'un emplacement libre dudit corps de lecteur de carte à mémoire.

2. Corps de lecteur de carte à mémoire selon la revendication 1, **caractérisé en ce que** ladite forme volumique dudit logement de réception 22 est sensiblement égale à la forme volumique du connecteur de carte à mémoire 10.

3. Corps de lecteur de carte à mémoire selon la revendication 1, **caractérisé en ce que** ladite face postérieure 21 dudit corps de lecteur de carte à mémoire comprend en outre au moins un logement complémentaire (40) de réception d'au moins un composant électronique.

4. Corps de lecteur de carte à mémoire selon la revendication 1, **caractérisé en ce que**, dans ledit logement de réception, ledit corps de lecteur de carte à mémoire comprend au moins un circuit de protection 23.

5. Corps de lecteur de carte à mémoire selon la revendication 4, **caractérisé en ce que** ledit circuit de protection 23 se présente sous la forme d'au moins un treillis comprenant ladite au moins une piste conductrice.

6. Corps de lecteur de carte à mémoire selon la revendication 4, **caractérisé en ce que** ledit circuit de protection 23 se présente sous la forme d'au moins une piste électrique continue comprenant ladite au moins une piste conductrice.

7. Corps de lecteur de carte à mémoire selon la revendication 4, **caractérisé en ce que** ledit circuit de protection 23 est réalisé par une technique de gravure au laser.

8. Corps de lecteur de carte à mémoire selon la revendication 4, **caractérisé en ce que** ledit circuit de protection 23 est un circuit imprimé flexible positionné au sein dudit logement de réception.

9. Corps de lecteur de carte à mémoire selon la revendication 4, **caractérisé en ce que** ladite face postérieure 21 dudit lecteur de carte à mémoire comprend au moins un logement complémentaire (40) de réception d'au moins un composant électronique, et **en ce que** ledit logement complémentaire (40) est positionné sous ledit circuit de protection 23.

10. Corps de lecteur de carte à mémoire selon la revendication 1, **caractérisé en ce que** ladite au moins une piste conductrice est conformée pour définir des zones de décharges électrostatiques entrant en contact avec une carte à puce lors de l'introduction de ladite carte à puce dans ledit corps de lecteur 20.

11. Terminal de lecture de carte à mémoire **caractérisé en ce qu'**il comprend un corps de lecteur de carte à mémoire 20 selon l'une des revendications 1 à 10.

## Patentansprüche

1. Speicherkartenlesekörper (20) von global parallelflacher rechteckiger Form, umfassend einen Schlitz (30) zum Einführen einer Speicherkarte, wobei der Lesekörper auf einer Rückseite (21) eine Lagerung (22) zur Aufnahme eines Speicherkartenanschlusses (10) umfasst, wobei die Aufnahmelagerung (22) eine vorbestimmte Volumenform hat, **dadurch gekennzeichnet, dass** der Speicherkartenlesekörper (20) auf der Rückseite (21) des Lesekörpers mindestens eine Schutzleiterbahn in der Nähe einer Kontaktzone von Polen des Speicherkartenanschlusses (10) umfasst, wobei die Bahn mindestens eine im Wesentlichen mit einem Volumen einer freien Stelle des Speicherkartenlesekörpers äquivalente Fläche bedeckt.

2. Speicherkartenlesekörper nach Anspruch 1, **dadurch gekennzeichnet, dass** die Volumenform der Aufnahmelagerung (22) im Wesentlichen gleich der Volumenform des Speicherkartenanschlusses (10) ist.

3. Speicherkartenlesekörper nach Anspruch 1, **dadurch gekennzeichnet, dass** die Rückseite (21) des Speicherkartenlesekörpers ferner mindestens eine komplementäre Lager (40) für die Aufnahme mindestens eines elektronischen Bauteils umfasst.

4. Speicherkartenlesekörper nach Anspruch 1, **dadurch gekennzeichnet, dass** in der Aufnahmelagerung der Speicherkartenlesekörper mindestens eine Schutzschaltung (23) umfasst.

5. Speicherkartenlesekörper nach Anspruch 4, **dadurch gekennzeichnet, dass** die Schutzschaltung (23) in Form von mindestens einem Gitter vorhanden ist, das die mindestens eine Leiterbahn umfasst.

6. Speicherkartenlesekörper nach Anspruch 4, **dadurch gekennzeichnet, dass** die Schutzschaltung (23) in Form mindestens einer durchgehenden elektrischen Bahn vorhanden ist, die die mindestens eine Leiterbahn umfasst.

7. Speicherkartenlesekörper nach Anspruch 4, **dadurch gekennzeichnet, dass** die Schutzschaltung (23) durch eine Lasergravurtechnik hergestellt ist.

8. Speicherkartenlesekörper nach Anspruch 4, **dadurch gekennzeichnet, dass** die Schutzschaltung (23) eine flexible gedruckte Schaltung ist, die in der Aufnahmelagerung angeordnet ist.

9. Speicherkartenlesekörper nach Anspruch 4, **dadurch gekennzeichnet, dass** die Rückseite (21) des Speicherkartenlesers mindestens eine komplementäre Lagerung (40) für die Aufnahme mindestens eines elektronischen Bauteils umfasst, und dass die komplementäre Lagerung (40) unter der Schutzschaltung (23) angeordnet ist.

10. Speicherkartenlesekörper nach Anspruch 1, **dadurch gekennzeichnet, dass** die mindestens eine Leiterbahn dazu vorgesehen ist, elektrostatische Entladezonen zu definieren, die mit einer Chipkarte bei der Einführung der Chipkarte in den Lesekörper (20) in Kontakt kommen.

11. Speicherkartenleseterminal, **dadurch gekennzeichnet, dass** es einen Speicherkartenlesekörper (20) nach einem der Ansprüche 1 bis 10 umfasst.

## Claims

1. Memory card reader body (20) with an overall rectangular parallelepiped shape comprising a slot (30) for inserting a memory card, the reader body comprising, on a rear face (21), a housing (22) for receiving a memory card connector (10), said housing (22) for receiving having a predetermined volume shape, **characterized in that** the memory card reader body (20) comprises, on the rear face (21) of the reader body, at least one protective conductive track in proximity to a contact zone of pins of the memory card connector (10), said tracking covering at least one surface appreciably equivalent to a volume of a free space of said memory card reader body.

2. Memory card reader body according to claim 1, **characterized in that** said volume shape of said housing (22) for receiving is substantially equal to the volume shape of the memory card connector (10).

3. Memory card reader body according to claim 1, **characterized in that** said rear face (21) of said memory card reader body furthermore comprises at least one complementary housing (40) to receive at least one electronic component.

4. Memory card reader body according to claim 1, **characterized in that**, in said housing for receiving, said memory card reader body comprises at least one protective circuit (23).

5. Memory card reader body according to claim 4, **characterized in that** said protective circuit (23) takes the form of at least one lattice comprising said at least one conductive track.

6. Memory card reader body according to claim 4, **characterized in that** said protective circuit (23) takes the form of at least one continuous electrical track comprising said at least one conductive track.

7. Memory card reader body according to claim 4, **characterized in that** said protective circuit (23) is made by means of a laser etching technique.

8. Memory card reader body according to claim 4, **characterized in that** said protective circuit (23) is a flexible printed circuit positioned within said housing for receiving.

9. Memory card reader body according to claim 4, **characterized in that** said rear face (21) of said memory card reader comprises at least one complementary housing (40) for receiving at least one electronic component and said complementary housing (40) is positioned beneath said protective circuit (23).

10. Memory card reader body according to claim 1, **characterized in that** said at least one conductive track is shaped to define electrostatic discharge zones coming into contact with a smart card when said smart card is introduced into said reader body (20).

11. Memory card reader terminal **characterized in that** it comprises a memory card reader body (20) according to any of the claims 1 to 10.
